# EUROPÄISCHE PATENTANMELDUNG

(11) **EP 2 489 756 A1**
(43) Veröffentlichungstag der Anmeldung: **22.08.2012**
(21) Anmeldenummer: 11192938.6
(22) Anmeldetag: 12.12.2011
(51) Int. Cl.: C23C 14/00, C23C 14/08, C03C 17/245

(54) **Beschichtungsverfahren, Schichtsystem sowie Verglasungselement**

(30) Priorität: 17.02.2011 DE 102011000800
(71) Anmelder: Glas Trösch Holding AG, 4922 Bützberg (CH)
(72) Erfinder: Graf, Roman, 4556 Starrkirch-Wil (CH); Kramer, Markus, Dr., 56412 Welschneudorf (DE); Schicht, Heinz, 06925 Bethau (DE); Kallèe, Klaus, 06188 Landsberg (DE)
(74) Vertreter: Schröer, Gernot H.

(57) **Zusammenfassung**

Die Erfindung betrifft insbesondere ein Beschichtungsverfahren für eine Substratoberfläche nitridischer Beschaffenheit. Zur Steigerung der chemischen und mechanischen Resistenz wird vorgeschlagen, auf die nitridische Substratoberfläche zumindest eine erste Schicht der Kategorie oxidisch, unteroxidisch, oxinitridisch, unteroxinitridisch oder nitridisch, und auf die zumindest eine erste Schicht eine zweite Schicht aus einem Zink-Zinn-Mischoxid abzuscheiden.

## Beschreibung

Die Erfindung betrifft ein Beschichtungsverfahren, ein Schichtsystem sowie ein Verglasungselement.

Verglasungselemente insbesondere im Wohnungs-, Gesellschafts-, oder Kraftfahrzeugbau können zur Verringerung des Wärmedurchgangs bekanntermaßen mit sog. Low-E-Schichtsystemen beschichtet werden. Solche Schichtsysteme können, beispielsweise zur Formgebung, mit Temperaturen von bis zu 700 bis 750 °C belastet werden, ohne dass ihre wesentlichen Eigenschaften wie Transmission im sichtbaren Spektralbereich, hohe Reflexion im infraroten Spektralbereich, geringe Lichtstreuung und hohe mechanische und chemische Beständigkeit wesentlich verschlechtert werden.

Für solche Schichtsysteme, die häufig eine obere nitridische Deckschicht aufweisen, ist es zur Erhaltung der wesentlichen Eigenschaften wünschenswert, wenn diese gegenüber mechanischen Einwirkungen, insbesondere tribologischen Beanspruchungen, geschützt sind. Denn bis zur Fertigstellung eines Verglasungselements, insbesondere einer Isolierglasscheibe, ist das Schichtsystem einer Vielzahl mechanischer Beanspruchungen ausgesetzt, wie dem Transport auf Rollenbahnen, dem Umstapeln von vertikaler in horizontale Lage, dem Verladen, dem Transport zum Isolierglasscheibenhersteller und Belastungen bei der Endmontage.

Ausgehend davon ist es insbesondere eine Aufgabe der Erfindung Möglichkeiten zu schaffen, mit welcher insbesondere nitridische Deckschichten, oder allgemeiner Substratoberflächen nitridischer Beschaffenheit, gegen mechanische Beanspruchungen geschützt werden können. Insbesondere sollen unter der vorgenannten Zielsetzung ein Beschichtungsverfahren für eine Substratoberfläche nitridischer Beschaffenheit, ein Schichtsystem sowie ein Verglasungselement angegeben werden.

Diese Aufgabe wird gelöst durch die unabhängigen Ansprüche. Ausgestaltungen ergeben sich aus den abhängigen Ansprüchen.

Nach Patentanspruch 1 ist ein Beschichtungsverfahren für eine Substratoberfläche nitridischer Beschaffenheit vorgesehen, bei welchem auf die nitridische Substratoberfläche zumindest eine erste Schicht der Kategorie oxidisch, unteroxidisch, oxinitridisch, unteroxinitridisch oder nitridisch, und auf die zumindest eine erste Schicht eine zweite Schicht aus einem Zink-Zinn-Mischoxid abgeschieden wird.

Dabei soll der Begriff "Substratoberfläche mit nitridischer Beschaffenheit" insbesondere bedeuten, dass die zu einem Substrat gehörige Substratoberfläche nitridische Eigenschaften aufweist, beispielsweise der Art Si₃N₄ ist. Möglich sind auch Substratoberflächen mit leicht unternitridischer Beschaffenheit. Das Substrat selbst kann aus mehreren Schichten aufgebaut sein, wobei in diesem Fall die Substratoberfläche durch eine nitridische Deckschicht ausgebildet werden kann. Die unter der Substratoberfläche ggf. gelegenen weiteren Schichten des Substrats können im Wesentlichen beliebiger Zusammensetzung und Beschaffenheit sein, d. h. diese können nicht-nitridischer Natur sein. Beispielsweise ist es möglich, dass das Substrat eine Schichtabfolge entsprechend einem Low-E-Schichtsystem aufweist, welches auf einer Glasscheibe oder einer Scheibe aus einem Glasersatzmaterial aufgebracht sein kann. Insbesondere kann es sich bei einem Substrat also um ein Verglasungselement mit einem Low-E-Schichtsystem handeln, wobei das Low-E-Schichtsystem eine die Substratoberfläche ausbildende Deckschicht aufweist. Im Sinne der Erfindung kann der Begriff "Substrat" jedoch auch lediglich das Low-E-Schichtsystem, oder allein die nitridische Deckschicht, sprich eine Schicht nitridischer Beschaffenheit, umfassen. Die nitridische Substratoberfläche kann insbesondere durch Abscheiden einer Schicht nitridischer Beschaffenheit, z. B. Si₃N₄, hergestellt werden bzw. sein. Dazu kann das Beschichtungsverfahren den weiteren Schritt der Abscheidung einer entsprechenden nitridischen Deckschicht umfassen.

Gemäß dem vorgeschlagenen Beschichtungsverfahren wird zumindest eine erste Schicht auf der Substratoberfläche abgeschieden. Das bedeutet, dass eine, zwei, drei usw. erste Schichten abgeschieden werden können. Insbesondere ist es möglich, dass zunächst eine erste Schicht abgeschieden wird, auf diese eine erste Schicht eine als Trennschicht bzw. Split-Schicht dienende weitere erste Schicht abgeschieden wird, und sodann auf die Trennschicht die zweite Schicht abgeschieden wird. Die so abgeschiedene Schichtfolge kann demnach zwischen der einen ersten Schicht und der zweiten Schicht eine Trennschicht aufweisen. Insbesondere daraus wird deutlich, dass im Sinne der Anmeldung die Begriffe "erste" und "zweite" als Hinweise auf die jeweilige Beschaffenheit verstanden werden, in dem Sinne, dass es sich bei der ersten Schicht um eine Schicht mit oxidischer, unteroxidischer, oxinitridischer, unteroxinitridischer oder nitridischer Beschaffenheit handelt, und dass es sich bei der zweiten Schicht um eine Schicht Zink-Zinn-mischoidischer Beschaffenheit handelt. Das bedeutet, dass das auf die Substratoberfläche abgeschiedene Schichtsystem zwei, drei, oder auch mehr Schichten umfassen kann.

Der Begriff "zumindest eine erste Schicht" soll die Fälle umfassen, in welchen i) lediglich eine erste Schicht auf die Substratoberfläche abgeschieden wird, und in welchen ii) mehrere aufeinanderfolgende erste Schichten, d. h. ein Schichtstapel aus ersten Schichten, d. h. Teildeckschichten, abgeschieden wird, bevor in einem weiteren Beschichtungsschritt die zweite Schicht abgeschieden wird. Für den Fall, dass mehrere erste Schichten, beispielsweise zwei erste Schichten, abgeschieden werden, sind diese, im Rahmen der nach Patentanspruch 1 gegebenen Möglichkeiten, vorzugsweise von unterschiedlicher Beschaffenheit. Letzteres bedeutet beispielsweise, dass auf die Substratoberfläche eine unteroxinitridische erste Schicht, darauf eine oxidische erste Schicht, gefolgt von der zweiten Schicht aus einem Zink-Zinn-Mischoxid abgeschieden werden.

Es hat sich gezeigt, dass die gemäß dem vorgeschlagenen Beschichtungsverfahren hergestellten Schichtfolgen auf der nitridischen Substratoberfläche gut haften, vorteilhafte chemische Resistenzen und besonders vorteilhafte Härteeigenschaften aufweisen. Dies gilt insbesondere für mechanische Belastungen, insbesondere tribologische Belastungen, welche bei Verglasungselementen, insbesondere Verglasungselementen mit Low-E-Schichtsystemen, insbesondere Isolierglasscheiben, bei deren Herstellung und üblicher Verwendung normalerweise auftreten. Damit eignet sich das Beschichtungsverfahren insbesondere zur Beschichtung von Verglasungselementen, insbesondere zur Beschichtung von Verglasungselementen mit Low-E-Schichtsystemen, sprich Isolierscheiben. Mithin eignet sich das Beschichtungsverfahren insbesondere für die Herstellung mechanisch und chemisch besonders belastbarer Verglasungselemente. Die Verglasungselemente können auf der Grundlage von Glasscheiben oder von Glasersatzscheiben, wie beispielsweise Kunststoffscheiben und dgl., hergestellt werden.

Die vorteilhafte chemische Resistenz und die vorteilhaften Härteeigenschaften liegen möglicherweise an der Zunahme der π-Elektronenkonzentration im Elektronensystem des Schichtaufbaus begründet. Denn π-Elektronen sind, insbesondere bei einer Schichtfolge aus einer ersten Schicht unteroxinitridischer Beschaffenheit, gefolgt von einer weiteren ersten Schicht oxidischer Beschaffenheit und einer zweiten Schicht aus ternärem Zink-Zinn-Mischoxid, delokalisierbar und können deswegen niederenergetische Zustände einzunehmen, welche die vorteilhaften Eigenschaften begünstigen. Es soll noch angemerkt werden, dass die bisher und nachfolgend beschriebenen Vorteile und vorteilhaften Eigenschaften besonders gut zum Tragen kommen, wenn zwischen Abschluss der Beschichtung und Weiterverarbeitung eine Lagerzeit von etwa 1 bis 2 Wochen im Glasblock erfolgt.

Besonders vorteilhaft kann das Beschichtungsverfahren angewandt werden bei nitridischen Substratoberflächen dielektrischer Beschaffenheit bzw. mit dielektrischen Eigenschaften. Vorzugsweise werden die dielektrischen Eigenschaften oder die dielektrische Beschaffenheit durch ein Dielektrikum der Gruppe Si₃N₄, AIN oder SiZrNₓ, bevorzugt Si₃N₄, ausgebildet. Für solche Dielektrika kann eine besonders vorteilhafte Haftung der ersten Schicht auf der Substratoberfläche erreicht werden.

Für die insbesondere bei Verglasungselementen bedeutsamen optischen Eigenschaften der Schichtfolge aus erster Schicht bzw. ersten Schichten und zweiter Schicht ist es insbesondere von Vorteil, wenn der Brechungsindex der Schicht/en, insbesondere der ersten Schicht, etwa im Bereich von 1,9 bis 2,0 liegt. Solche Brechungsindices können insbesondere durch eine, ggf. mehrere, unteroxynitridische erste Schichten, bevorzugt der Zusammensetzung Si₃N₄₋ₙOₙ, erreicht werden. Durch eine geeignete Einstellung der optischen Eigenschaften kann eine vorteilhafte optische Kopplung zwischen der/den jeweiligen ersten Schicht/en und jeweils darunter und/oder darüber liegenden weiteren Schichten erreicht werden.

In einer besonders vorteilhaften Ausgestaltung der Erfindung umfasst eine der zumindest einen ersten Schicht das Element Silizium und/oder zumindest eine der zumindest einen ersten Schicht umfasst eine Metall-Metall-Paarung der Gruppe CrNi, TiAl, NiAL. Insbesondere die vorgenannten ersten Schichten mit einer Metall-Metall-Paarung können entweder unmittelbar auf der Substratoberfläche, oder vorzugsweise als Zwischen, Trenn- bzw. Split-Schicht zwischen einer ersten Schicht und einer darauf folgenden zweiten Schicht abgeschieden werden. Eine Schicht, welche eine der vorgenannten Metall-Metall-Paarungen umfasst, kann als rein unteroxidische, gemischt oxinitridische oder nitridische Verbindung abgeschieden sein. Insbesondere kommen damit Verbindungen, und daraus hergestellte Split-Schichten, in Frage wie beispielsweise (erNi)Oₓ, (Ti-Al)Oₓ, (NiAl) Oₓ, (CrNi)OₓN_{y}, (TiAl)OₓN_{y}, (NiAl)OₓN_{y}, (CrNi)N_{y}, (TiAl)N_{y} und (NiAl)N_{y}.

Insbesondere zur Erreichung eines gewünschten Brechungsindex, beispielsweise im Bereich von 1,9 bis 2,0, jedoch auch für andere Schichtparameter und Schichteigenschaften, kann es von Vorteil sein, wenn ein reaktiver Plasmasputterprozess zur Abscheidung der zumindest einen ersten und/oder zweiten Schicht verwendet wird. Beispielsweise ist es möglich, dass der Plasmasputterprozess in Stickstoff- und/oder Sauerstoffatmosphäre, insbesondere unter Zusatz von Argon, erfolgt. Die gesamte Schichtfolge, d. h. die zumindest eine erste Schicht und die zweite Schicht, kann in Vakuumfolge auf dem Substrat abgeschieden werden.

Bei einer vorteilhaften Verfahrensvariante wird beim Plasmasputterprozess zum Aufbringen der oxidischen, unteroxidischen, oxinitridischen oder unteroxinitridischen, vorzugsweise unteroxinitridischen, ersten Schicht der Sauerstoffgehalt in der Plasmasputteratmosphäre, insbesondere in einer Ar, N₂, O₂ Atmosphäre, derart eingestellt, dass der Brechungsindex der ersten Schicht etwa im Bereich von 1,9 bis 2,0 liegt. Das kann beispielsweise erfolgen, indem der Sauerstoffgehalt in der Plasmasputteratmosphäre auf weniger als 6 sccm (Standardkubikzentimeter) eingestellt wird.

Die zumindest eine erste Schicht kann bei einer Ausgestaltung des Beschichtungsverfahrens in einer Dicke etwa im Bereich von 0,5 bis 1,5 nm abgeschieden werden. Die zweite Schicht kann in einer Dicke etwa im Bereich von 2 bis 5 nm abgeschieden werden. Solche Dicken eignen sich insbesondere für die Beschichtung von Verglasungselementen, insbesondere für die Beschichtung von Low-E-Schichtsystemen.

In einer besonders bevorzugten Ausgestaltung ist die zweite Schicht ein ternäres Zn-Sn-Mischoxid, welches zumindest einen Dotierstoff der Gruppe Ni, Mg, Sb, AI, Cu umfasst, vorzugsweise in einem Gehalt etwa im Bereich von 0,25 bis 6,5 Gew.%. Mit solchen Schichten als Schichtabschluss können besonders vorteilhafte chemische und physikalische Eigenschaften, wie z. B. eine vergleichsweise hohe Härte, erreicht werden. Dem Zn-Sn-Mischoxid kann auch eine Legierung umfassend zumindest zwei der genannten Elemente Ni, Mg, Sb, Al, Cu zudotiert sein. Die Tatsache, dass auch eine Legierung zudotiert sein kann, ergibt sich aus den Ansprüchen dadurch, dass zumindest eines der genannten Elemente zudotiert sein kann. Von besonderem Vorteil für das Schichtsystem kann es sein, wenn auf die vollstöchiometrische Substratoberfläche eine unteroxynitridische erste Schicht, darauf eine weitere erste Schicht, die als Trenn- bzw. Split-schicht dient, und darauf die zweite Schicht abgeschieden wird. Als Split-schicht kommen Schichten umfassend die Verbindungen (CrNi)Oₓ, (Ti-Al)Oₓ, (NiAl) Oₓ, (CrNi)OₓN_{y}, (TiAl)OₓN_{y}, (NiAl)OₓN_{y}, (CrNi)Ny, (TiAl)N_{y} und (NiAl)N_{y}, in Frage.

Die bereits genannten Vorteile und vorteilhaften Eigenschaften können insbesondere mit den nachfolgend genannten Schichtfolgen aus erster/ersten Schicht/en und zweiter Schicht erreicht werden:

Si₃N₄₋ₙOₙ / (ZnSnM1)Oₓ;

Si₃N₄₋ₙOₙ / (M2M2)Ox / (ZnSnM1)Oₓ;

(M2M2)Oₓ / (ZnSnM1)Oₓ;

(M2M2)OₓN_{y} / (ZnSnM1)Oₓ;

(M2M2)N_{y} / (ZnSnM1)Oₓ.

Dabei ist M1 ausgewählt aus der Gruppe umfassend Al, Ni, Mg, Sb, Cu, und M2M2 ist ausgewählt aus der Gruppe umfassend CrNi, TiAl, NiAl. Insbesondere für diese Schichtfolgen kann für nitridische Substratoberflächen eine gute Haftung erreicht werden. Ferner können vergleichsweise gute chemische und physikalische Eigenschaften, wie Säureresistenz, Härte, Unempfindlichkeit gegenüber tribologischen Belastungen usw. erreicht werden. Insgesamt können also, wie oben bereits ausgeführt, verbesserte Produkteigenschaften erreicht werden.

Wie bereits erwähnt, kann das Substrat ein Verglasungselement, insbesondere mit einem Low-E-Schichtsystem, umfassen. Es ist also möglich, dass es sich bei der Substratoberfläche um die Oberfläche einer nitridischen Deckschicht des Low-E-Schichtsystems handelt. Das Low-E-Schichtsystem mit Deckschicht kann auf einer Scheibe, insbesondere aus Glas oder einem Glasersatzstoff, aufgebracht sein. Wie daraus und aus den vorherigen Ausführungen ersichtlich, eignet sich die vorgeschlagene Schichtfolge für die Verwendung bei Verglasungselementen mit Low-E-Schichtsystemen. Allerdings ist die Verwendung der Schichtfolge nicht diese Anwendung beschränkt, sondern kann vielmehr für beliebige Substrate, insbesondere dielektrische Substrate usw. verwendet werden. Wegen Vorteilen und vorteilhaften Wirkungen wird auf die obigen Ausführungen zum Beschichtungsverfahren und dessen Ausgestaltungen verwiesen.

Nach Patentanspruch 13 ist ein Schichtsystem, insbesondere ein Low-E-Schichtsystem, vorgesehen, umfassend ein Substrat mit einer Substratoberfläche nitridischer Beschaffenheit, vorzugsweise einer Deckschicht des Low-E-Schichtsystems. Auf die Substratoberfläche ist eine Schichtfolge abgeschieden gemäß dem vorgeschlagenen Beschichtungsverfahren oder nach einer Ausgestaltung desselben, d. h. es ist, wie im Zusammenhang mit Patentanspruch 1 und entsprechenden Ausgestaltungen ausgeführt wurde, zumindest eine erste Schicht und die zweite Schicht abgeschieden. Die im Zusammenhang mit dem Beschichtungsverfahren und dessen Ausgestaltungen erwähnten Vorteile und vorteilhaften Wirkungen gelten hier entsprechend, so dass besonders vorteilhafte, insbesondere verbesserte, Produkteigenschaften erreicht werden können.

Nach Patentanspruch 14 ist ein Verglasungselement vorgesehen, welches das vorweg beschriebene Schichtsystem umfasst, welches mit dem weiter oben beschriebenen Beschichtungsverfahren aufgebracht sein kann. Solche Verglasungselemente weisen besonders vorteilhafte Eigenschaften auf, insbesondere hinsichtlich chemischer Beständigkeit und Härte usw. Insbesondere deswegen eignen sich solche Verglasungselemente besonders für den Wohnungs-, Gesellschafts- oder Kraftfahrzeugbau.

Nachfolgend werden Ausführungsbeispiele der Erfindung in Gegenüberstellung zu einem dem Stand der Technik entsprechenden Vergleichsbeispiel beschrieben. Im Folgenden wird zunächst auf das Vergleichsbeispiel eingegangen, gefolgt von zwei konkreten Ausführungsbeispielen.

### Vergleichsbeispiel:

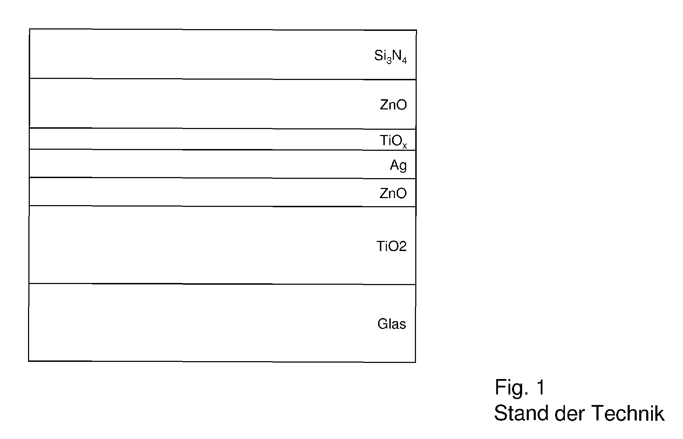

Auf einer großtechnischen Anlage, mit welcher ganze Bandmaße Floatglas der Abmessungen 6x3,21 m² beschichtet werden können, wurden Probescheiben mit einer Dicke von etwa 4 mm hergestellt. Die Probenscheiben wiesen den folgenden, auch in Fig. 1 schematisch dargestellten, Schichtaufbau auf:

Glas / (20)TiO₂ / (6)ZnO / (10)Ag / (4)TiOₓ / (28)ZnO / (8)Si₃N₄.

Dabei bezeichnen die in Klammern den einzelnen Schichten vorgestellten Zahlen die Dicke der jeweiligen Schicht in Nanometer (nm). Konkret handelt es sich bei der Probescheibe um eine mit einem Low-E-Schichtsystem beschichtete Glasscheibe, wobei die Si₃N₄ eine vollstöchiometrische Deckschicht bildet.

Die so hergestellte Probescheibe wurde anschließend auf chemische Resistenz und Härte geprüft, wobei die entsprechenden Tests erst nach einer Atmosphärenkontaktzeit der Probescheibe von 2 Stunden durchgeführt wurden. D. h. die Probescheibe war zwischen Herstellung und Test für eine Dauer von 2 Stunden atmosphärischen Bedingungen ausgesetzt.

Zur Prüfung der Härte wurde der Ritzhärtetest nach Erichsen verwendet. Bei diesem Test wird eine mit einer Gewichtskraft beaufschlagte Spitze mit konstanter Geschwindigkeit, in kreisförmiger Bewegung, auf der zu untersuchenden Oberfläche bewegt, wobei diejenige Gewichtskraft ermittelt wird, bei welcher sichtbare Zerkratzungen, z. B. unterbrochene Ritze, auf der Oberfläche erkennbar sind.

Die chemische Resistenz der Probescheibe wurde nach ASTM 2486 geprüft.

Für den Ritzhärtetest ergab sich eine Gewichtskraft von 0,32 Newton. Für den Test auf chemische Härte nach ASTM 2486 ergaben sich nach 300 Hüben leichte Scheuerstreifen.

### Ausführungsbeispiel 1:

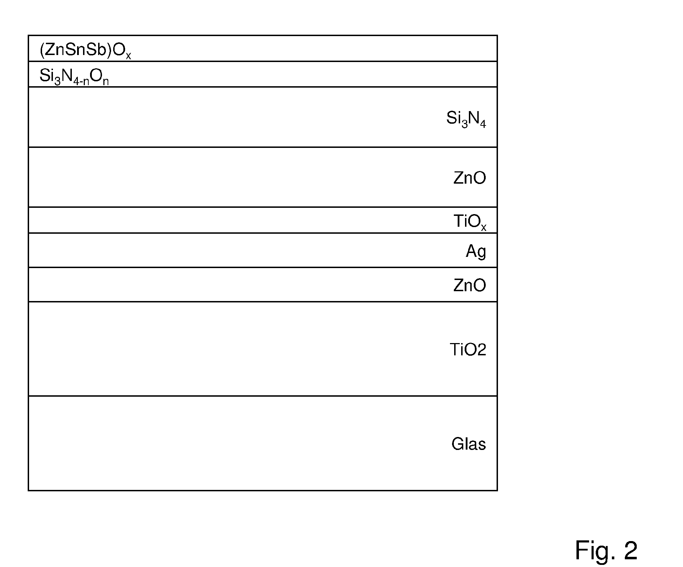

Auf eine Probescheibe gemäß dem Vergleichbeispiel wurde, wie in Fig. 2 schematisch dargestellt, in einer Laboranlage Z600 (des Herstellers Leybold) auf die vorhandene nitridische Si₃N₄-Deckschicht des Low-E-Schichtsystems eine weitere Schichtfolge aus einer ersten Schicht und einer zweiten Schicht abgeschieden.

Als erste Schicht wurde in einem Plasmatronsputterprozess unter Verwendung eines planaren Si-Targets unter einer Ar, N₂, O₂ - Gasatmosphäre mit einem O₂-Gehalt von weniger als 6 sccm eine unteroxynitridische Si₃N₄₋ₙOₙ-Schicht in einer Dicke von etwa 4 nm abgeschieden.

Auf diese erste Schicht wurde in Vakuumfolge eine etwa 4 nm dicke (ZnSnSb)Oₓ - Schicht, d. h. eine ternäre Mischoxidschicht, abgeschieden.

Die mit der weiteren Schichtfolge aus erster und zweiter Schicht beschichteten Probescheiben wurden analog zum Vergleichsbeispiel auf chemische Resistenz und Härte untersucht.

Für den Ritzhärtetest ergab sich eine Gewichtskraft von 2,6 Newton. Bei dem Test auf chemische Härte nach ASTM 2486 war das Schichtsystem nach 300 Hüben ohne Fehler.

Das zeigt, dass durch die zusätzliche Schichtfolge aus erster und zweiter Schicht die chemische Resistenz und Härte deutlich verbessert werden können.

### Ausführungsbeispiel 2:

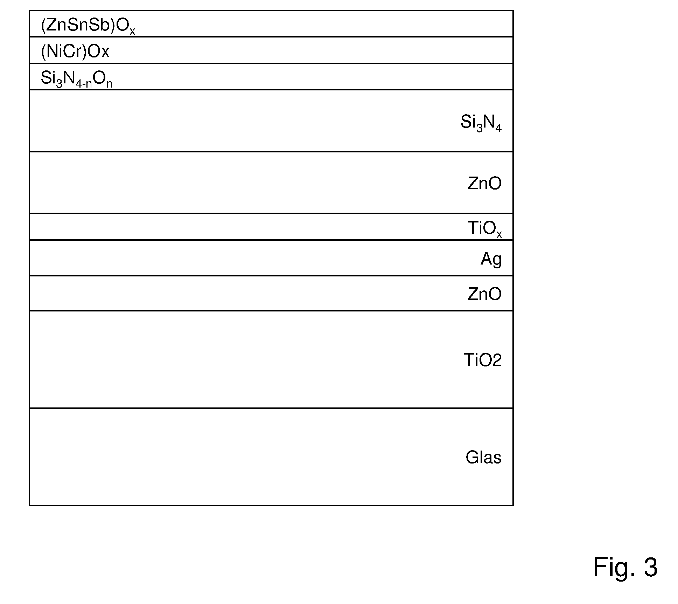

Auf eine Probescheibe gemäß dem Vergleichbeispiel wurde, wie in Fig. 3 schematisch dargestellt, in einer Laboranlage Z600 (des Herstellers Leybold) auf die vorhandene nitridische Si₃N₄-Deckschicht, des Low-E-Schichtsystems, eine weitere Schichtfolge aus einer ersten Schicht, einer weiteren ersten und einer zweiten Schicht abgeschieden.

Die erste Schicht entspricht der des Ausführungsbeispiels 1.

Als weitere erste Schicht wurde auf die bereits bestehende erste Schicht in Vakuumfolge bei 0,7 W Leistung, einem Argonfluss von 80 sccm und einem Sauerstofffluss von 30 sccm O₂ eine teiloxidierte (NiCr)Oₓ - Schicht, als Split-Schicht, in einer Dicke von 1,3 nm abgeschieden.

Auf diese weitere erste Schicht, d. h. auf diese Split-Schicht, wurde in Vakuumfolge bei 0,7 W Leistung, einem Argonfluss von 100 sccm und einem Sauerstofffluss von 40 sccm eine etwa 3 nm dicke (ZnSnSb)Oₓ - Schicht, d. h. eine ternäre Mischoxidschicht, als zweite Schicht abgeschieden.

Die so beschichteten Probescheiben wurden analog zu vorher auf chemische Resistenz und Härte getestet.

Für den Ritzhärtetest ergab sich eine Gewichtskraft von 3,2 Newton. Bei dem Test auf chemische Härte nach ASTM 2486 war das Schichtsystem nach 300 Hüben ohne Fehler.

Das zeigt, dass durch die zusätzliche Schichtfolge aus erster, weiterer erster und zweiter Schicht die chemische Resistenz und Härte, gegenüber dem Vergleichsbeispiel und insbesondere auch noch gegenüber dem ersten Ausführungsbeispiel deutlich verbessert werden können.

Die besonders vorteilhaften Eigenschaften der hierin vorgeschlagenen Schichtfolge zur Steigerung der Härte und zur Verbesserung der chemischen und physikalischen Eigenschaften wurden in den Ausführungsbeispielen beispielhaft anhand der zwei Schichtfolgen

Si₃N₄₋ₙOₙ / (4) (ZnSnSb)Oₓ und (4)

Si₃N₄₋ₙOₙ / (1,5) (NiCr)Oₓ / (4) (ZnSnSb)Oₓ, (4)

beschrieben, wobei die in Klammern den jeweiligen Schichten vorgestellten Zahlen die Dicke der Schichten angeben.

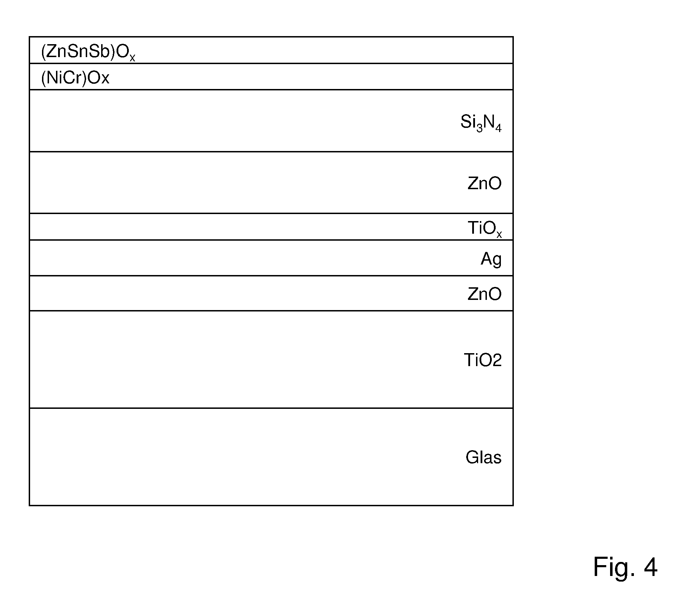

Über die beiden Ausführungsbeispiele hinaus liegt es im Rahmen der Erfindung, und es können hinsichtlich chemischer und physikalischer Resistenz sowie Härte analoge Ergebnisse erzielt werden, wenn, insbesondere auf einer vollstöchiometrischen Si₃N₄ -Schicht, eine der folgenden Schichtfolgen verwendet wird:
1. Si₃N₄₋ₙOₙ / (ZnSnM1)Oₓ
2. Si₃N₄₋ₙOₙ / (M2M2)Oₓ / (ZnSnM1)Oₓ
3. (M2M2)Oₓ / (ZnSnM1)Oₓ
4. (M2M2)OₓN_{y} / (ZnSnM1)Oₓ
5. (M2M2)Oₓ / (ZnSnM1)Oₓ,
wobei es sich bei M1 um eines der Metalle Ni, Mg, Sb, Al, Cu, und M2M2 um eine der folgenden Metall-Metall-Paarungen NiCr, TiAl, NiAl handeln kann. Zur Verdeutlichung der unter 3. bis 5. genannten Möglichkeiten ist in Fig. 4 ein Beispiel gezeigt, bei welchem auf die vollstöchiometrische Si₃N₄ - Schicht eine Schicht aus einer oxydischen Metall-Metall-Paarung und auf diese erste Schicht die zweite Schicht (ZnSnSb)Oₓ abgeschieden ist.

Es soll angemerkt werden, dass die erwähnten vorteilhaften Eigenschaften besonders gut zum Tragen kommen, wenn zwischen Beschichtungsabschluss, d. h. nach Aufbringen des Schichtsystems aus zumindest der einen ersten Schicht und der zweiten Schicht, und Weiterverarbeitung des mit dem Schichtsystem versehenen Substrats eine Lagerzeit von 1 bis 2 Wochen im Glasblock liegt.

Insgesamt wird deutlich, dass mit dem vorgeschlagenen Beschichtungsverfahren, dem vorgeschlagenen Schichtsystem, sowie bei dem vorgeschlagenen Verglasungselement eine Oberfläche erzeugt werden kann, welche hinsichtlich mechanischer, insbesondere tribologischer, und chemischer Einwirkungen besonders stabil und resistent ist. Das vorgeschlagene Beschichtungsverfahren und Schichtsystem eignet sich in besonderer Weise zum Schutz von Low-E-Schichtsystemen, insbesondere von Isolierverglasungen.

## Patentansprüche

1. Beschichtungsverfahren für eine Substratoberfläche nitridischer Beschaffenheit, wobei auf Substratoberfläche zumindest eine erste Schicht der Kategorie oxidisch, unteroxidisch, oxinitridisch, unteroxinitridisch oder nitridisch, und auf die zumindest eine erste Schicht eine zweite Schicht aus einem Zink-Zinn-Mischoxid abgeschieden wird.

2. Beschichtungsverfahren nach Anspruch 1, wobei auf die Substratoberfläche eine erste Schicht der Kategorie unteroxynitridisch, darauf eine, als Split-Schicht dienende, weitere erste Schicht und auf die weitere erste Schicht die zweite Schicht, vorzugsweise in Vakuumfolge, abgeschieden werden.

3. Beschichtungsverfahren nach einem der Ansprüche 1 oder 2, wobei die nitridische Substratoberfläche dielektrischer Beschaffenheit ist, vorzugsweise gebildet durch zumindest ein Dielektrikum der Gruppe Si₃N₄, AIN, SiZrNₓ, bevorzugt Si₃N₄.

4. Beschichtungsverfahren nach einem der Ansprüche 1 bis 3, wobei die zumindest eine erste Schicht derart abgeschieden wird, dass deren Brechungsindex etwa im Bereich von 1,9 bis 2,0 liegt.

5. Beschichtungsverfahren nach einem der Ansprüche 1 bis 3, wobei zumindest eine der zumindest einen ersten Schicht das Element Silizium und/oder zumindest eine der zumindest einen ersten Schicht, insbesondere eine als Split-Schicht dienende erste Schicht, eine Metall-Metall-Paarung der Gruppe CrNi, TiAl, NiAl umfasst.

6. Beschichtungsverfahren nach einem der Ansprüche 1 bis 5, wobei zumindest die zumindest eine erste Schicht mittels eines reaktiven Plasmasputterprozesses, insbesondere unter Stickstoff- und/oder Sauerstoffatmosphäre abgeschieden wird.

7. Beschichtungsverfahren nach Anspruch 6, wobei die erste Schicht der Kategorie oxidisch, unteroxidisch, oxinitridisch oder unteroxinitridisch, vorzugsweise unteroxinitridisch, ist, und beim Plasmasputterprozess der Sauerstoffgehalt Plasmasputteratmosphäre derart eingestellt wird, vorzugsweise auf weniger als 6 sccm, dass der Brechungsindex der ersten Schicht etwa im Bereich von 1,9 bis 2,0 liegt.

8. Beschichtungsverfahren nach einem der Ansprüche 1 bis 7, wobei die zumindest eine erste Schicht in einer Dicke im Bereich von etwa 0,5 bis 1,5 nm abgeschieden wird, und/oder die zweite Schicht in einer Dicke im Bereich von etwa 2 bis 5 nm abgeschieden wird.

9. Beschichtungsverfahren nach einem der Ansprüche 1 bis 8, wobei die zweite Schicht ein ternäres Zn-Sn-Mischoxid ist, umfassend zumindest einen Dotierstoff der Gruppe Ni, Mg, Sb, Al, Cu, vorzugsweise in einem Gehalt etwa im Bereich von 0,25 bis 6,5 Gew.%.

10. Beschichtungsverfahren nach einem der Ansprüche 1 bis 9, wobei die zumindest eine erste Schicht und die zweite Schicht als eine der folgenden Schichtfolgen abgeschieden werden: Si₃N₄₋ₙOₙ / (ZnSnM1)Oₓ; Si₃N₄₋ₙOₙ / (M2M2)Ox / (ZnSnM1)Oₓ; (M2M2)Oₓ / (ZnSnM1)O_{x;} (M2M2)OₓN_{y} / (ZnSnM1)Oₓ; (M2M2)Ny / (ZnSnMl)Oₓ; wobei M1 ausgewählt ist aus der Gruppe umfassend Al, Ni, Mg, Sb, Cu, und wobei M2M2 ausgewählt ist aus der Gruppe umfassend CrNi, TiAl, NiAl.

11. Beschichtungsverfahren nach einem der Ansprüche 1 bis 10, wobei die Substratoberfläche durch eine nitridischen Deckschicht eines auf einer Scheibe, insbesondere aus Glas oder einem Glasersatzstoff, aufgebrachten Low-E-Schichtsystems gebildet ist.

12. Beschichtungsverfahren nach einem der Ansprüche 1 bis 11, wobei ein Substrat umfassend das Schichtsystem aus der zumindest einen erste Schicht und zweiten Schicht für einen Zeitraum von etwa 1 bis 2 Wochen gelagert wird.

13. Schichtsystem, insbesondere Low-E-Schichtsystem, umfassend ein Substrat mit einer Substratoberfläche nitridischer Beschaffenheit, vorzugsweise einer Deckschicht des Low-E-Schichtsystems, wobei auf die Substratoberfläche eine Schichtfolge aus zumindest einer ersten Schicht und einer zweiten Schicht nach einem Beschichtungsverfahren nach einem der Ansprüche 1 bis 12 abgeschieden ist.

14. Verglasungselement, insbesondere für den Wohnungs-, Gesellschafts- oder Kraftfahrzeugbau, umfassend ein Schichtsystem nach Anspruch 13.
